# EUROPEAN PATENT APPLICATION

(11) **EP 3 670 739 A1**
(43) Date of publication of application: **24.06.2020**
(21) Application number: 18861991.0
(22) Date of filing: 20.04.2018
(51) Int. Cl.: D06M 11/83, B32B 15/02, B32B 15/20, B32B 37/06, B32B 33/00, H05K 9/00, D06M 101/40, B32B 5/26

(54) **NICKLE PLATED CARBON FIBER FILM, MANUFACTURING METHOD THEREFOR, SHIELDING STRUCTURE AND PREPARATION METHOD THEREFOR**

(30) Priority: 30.09.2017 CN 201710941915
(71) Applicant: CRRC Qingdao Sifang Co., Ltd., Qingdao City, Shandong 266111 (CN)
(72) Inventor: LIANG, Jianying, Qingdao Shandong 266111 (CN); XIAO, Chanjuan, Qingdao Shandong 266111 (CN); JIAO, Jinghai, Qingdao Shandong 266111 (CN); TIAN, Qing, Qingdao Shandong 266111 (CN); WANG, Yong, Qingdao Shandong 266111 (CN); LIU, Yuwen, Qingdao Shandong 266111 (CN)
(74) Representative: Long, Giorgio
(86) International application number: PCT/CN2018/083919
(87) International publication number: WO 2019/062089

(57) **Abstract**

Provided in the present disclosure are a nickel-plated carbon fiber film, a manufacturing method of the nickel-plated carbon fiber film, a shielding structure and a preparation method of the shielding structure. The nickel-plated carbon fiber film comprises: at least one carbon fiber base fabric, metal colloid particles adhering to a surface of the carbon fiber base fabric; at least one nickel metal layer, which is provided on a surface of the carbon fiber base fabric and a surface of the metal colloid particles that is far from the carbon fiber base fabric. In the nickel-plated carbon fiber film, metal colloid particles is adhesive such that the nickel metal layer better adheres to the carbon fiber base fabric; the electromagnetic shielding performance of the nickel-plated carbon fiber film is further enhanced such that the nickel-plated carbon fiber film has better mechanical and physical performance while also having better electromagnetic shielding performance.

## Description

### Technical Field

The present disclosure relates to the field of shielding materials, and in particular, to a nickel-plated carbon fiber film, a manufacturing method of the nickel-plated carbon fiber film, a shielding structure and a preparation method of the shielding structure.

### Background

It is well-known that shielding effectiveness is a basis of measuring capacity of an electromagnetic shielding composite material. A shielding effectiveness requirement of general industrial electronic equipment is greater than 30 dB, but about a shielding material of precise instrument equipment, 50 dB and even more than 60 dB of the shielding effectiveness is required, at the same time the material must also have good environment using stability, so the electronic equipment can be steadily worked in various environments.

It is known according to numerous reports that various conductive high-molecular materials realize higher physical and mechanical properties while the shielding effectiveness thereof is difficult to meet the using requirement, but the physical and mechanical properties of the composite material massively doped with conductive filler are also difficult to meet actual use.

### Summary

A main purpose of the present disclosure is to provide a nickel-plated carbon fiber film, a manufacturing method of the nickel-plated carbon fiber film, a shielding structure and a preparation method of the shielding structure, as to solve a problem that a nickel-plated carbon fiber film in an existing technology does not have both the better physical and mechanical properties and shielding effectiveness.

In order to achieve the purpose, according to one aspect of the present disclosure, a nickel-plated carbon fiber film is provided, the nickel-plated carbon fiber film includes: at least one carbon fiber base fabric, and metal colloid particles are adhered to a surface of the carbon fiber base fabric; and at least one nickel metal layer, arranged on a naked surface of the carbon fiber base fabric and a surface, away from the carbon fiber base fabric, of the metal colloid particles.

In an optional embodiment, the metal colloid particles are Pb colloid particles or Ag colloid particles.

In order to achieve the purpose, according to another aspect of the present disclosure, a shielding structure is provided, the shielding structure includes at least one shielding component, and the shielding component includes the nickel-plated carbon fiber film.

In an optional embodiment, the shielding component further includes: at least one carbon fiber fabric, and the nickel-plated carbon fiber film is arranged on a side surface of the carbon fiber fabric, and preferably a thickness of one or more the carbon fiber fabric is between 0.13 and 1.0 mm.

In an optional embodiment, the shielding component further includes: at least one metal net, arranged between the nickel-plated carbon fiber film and the carbon fiber fabric, preferably the metal net is a copper net, and further preferably a thickness of the metal net is between 0.005 and 0.015 mm.

In an optional embodiment, the shielding component further includes: at least one permalloy layer, arranged on a surface, away from the metal net, of the nickel-plated carbon fiber film, preferably a thickness of the permalloy layer is between 0.05 and 0.20 mm, further preferably the shielding component includes a plurality of stacked nickel-plated carbon fiber films, a total thickness of the a plurality of the nickel-plated carbon fiber films is between 0.7 and 1.2 mm.

In an optional embodiment, the shielding structure includes a plurality of the shielding components, each of the plurality of shielding components is stacked, the shielding structure further includes: at least one adhesive layer, arranged between any adjacent two of the shielding components and between any adjacent two of structure layers in each of the shielding components, preferably a raw material of the adhesive layer includes 80-120 parts by weight of epoxy resin, 60-80 parts by weight of curing agent, and 0.5-2.5 parts by weight of accelerant, further preferably the curing agent is methyl tetrahydrophthalic anhydride, and the accelerant is boron trifluoride ethylamine.

In order to achieve the purpose, according to the other aspect of the present disclosure, a manufacturing method of a nickel-plated carbon fiber film is provided, and the manufacturing method includes: step S1, at least one carbon fiber base fabric is provided; step S3, metal colloid particles are arranged on the carbon fiber base fabric; and step S4, at least one nickel metal layer is arranged on a naked surface of the carbon fiber base fabric and a surface, away from the carbon fiber base fabric, of the metal colloid particles.

In an optional embodiment, between the step S1 and the step S3, the manufacturing method further includes: step S2, surfaces of the carbon fiber base fabric is treated, as to remove organic matters on the surface of the carbon fiber base fabric.

In an optional embodiment, the step S2 includes the following steps: the carbon fiber base fabric is soaked with acetone; the carbon fiber base fabric soaked with the acetone is soaked with mixed solution of a hydrofluoric acid and a strong acid; and the soaked carbon fiber base fabric is washed with water.

In an optional embodiment, the strong acid is a sulfuric acid, a hydrochloric acid or a nitric acid, preferably a molar ratio of the hydrofluoric acid and the strong acid is between 1:3 and 1:1, further preferably a volume concentration of the mixed solution is between 5% and 15%, and more preferably in the step S2, a time of soaking the carbon fiber base fabric with the mixed solution is between 5 and 30 min.

In an optional embodiment, the step S3 includes: step S31, the carbon fiber base fabric is soaked with a dilute acid solution of a reducing metal salt; step S32, the carbon fiber base fabric treated in the step S31 is activated with a dilute acid solution of an oxidizing metal salt, as to generate the metal colloid particles, preferably the oxidizing metal salt is PdCl₂ or AgNO₃, and further preferably the reducing metal salt is SnCl₂.

In an optional embodiment, the dilute acid solution of the reducing metal salt in the step S31 is a first hydrochloric acid solution, and in the first hydrochloric acid solution, a mass concentration of the SnCl₂ is between 4% and 8%, preferably a soaking temperature of the step S31 is between 25ºC and 40ºC, and a soaking time is between 20 min and 50 min.

In an optional embodiment, the oxidizing metal salt is PdCl₂, the dilute acid solution of the oxidizing metal salt in the step S32 is a second hydrochloric acid solution, and in the second hydrochloric acid solution, a mass concentration of the PdCl₂ is between 0.02% and 0.04%, preferably a temperature of the dilute acid solution of the PdCl₂ is between 25ºC and 40ºC, and a time of the activating treatment is between 10 min and 50 min.

In an optional embodiment, after the carbon fiber base fabric is soaked with the dilute acid solution of the SnCl₂, the step S31 further includes the following steps: the carbon fiber base fabric is washed with water, and the oxidizing metal salt is PdCl₂, after the carbon fiber base fabric is activated with the dilute acid solution of PdCl₂, the step S32 further includes the following step: the carbon fiber base fabric is washed with the water.

In an optional embodiment, the step S4 includes the following steps: a plating solution is adopted, and the nickel metal layer is arranged with an electroless nickel plating, preferably the plating solution includes 40-60 parts by weight of nickel salt, 40-60 parts by weight of reducing agent, 80-120 parts by weight of complexing agent, 40-60 parts by weight of buffering agent and 0.15-0.25 parts by weight of surfactant, further preferably a pH value of the plating solution is 10-11.

In an optional embodiment, the nickel salt includes nickel sulfate, the reducing agent includes sodium hypophosphite, the complexing agent includes sodium citrate, the buffering agent includes ammonium chloride, and the surfactant includes sodium dodecyl benzene sulfonate, preferably a temperature of the plating solution is between 40ºC and 60ºC, further preferably an implementation time of the electroless nickel plating is between 20 min and 50 min.

According to another aspect of the present disclosure, a preparation method of a shielding structure is provided, the preparation method includes a manufacturing process of at least one shielding component, and the manufacturing process includes a manufacturing method of any one of the nickel-plated carbon fiber films.

In an optional embodiment, the manufacturing process further includes the following steps: a carbon fiber fabric is provided; and at least one metal net and the nickel-plated carbon fiber film are sequentially arranged on the carbon fiber fabric, preferably the manufacturing process further includes the following steps: at least one permalloy layer is arranged on a surface, away from the metal net, of the nickel-plated carbon fiber film, as to form a pre-shielding component.

In an optional embodiment, the preparation method further includes the following steps: the pre-shielding component is hot pressed or a plurality of stacked pre-shielding components is hot pressed, as to form the shielding structure.

In an optional embodiment, a process of the hot pressing includes the following steps: an adhesive is arranged between the adjacent structure layers to be hot pressed, as to form a pre-hot press structure; the pre-hot press structure is pressed; the adhesive in the pre-hot press structure after pressing is cured, preferably the adhesive includes 80-120 parts by weight of epoxy resin, 60-80 parts by weight of curing agent, and 0.5-2.5 parts by weight of accelerant, preferably the curing agent is methyl tetrahydrophthalic anhydride, the accelerant is boron trifluoride ethylamine, further preferably a pressure of the lamination is between 0.4 MPa and 0.8 MPa, more preferably the curing is heat curing, and a temperature of the heat curing is between 120ºC and 150ºC, and a time of the heat curing is between 1 h and 3 h.

A technical scheme of the present disclosure is applied, in the nickel-plated carbon fiber film, the metal colloid particles are adhered to the carbon fiber base fabric, the metal colloid particles have an adhesion property, so the nickel metal layer is adhered to the carbon fiber base fabric better, the electromagnetic shielding effectiveness of the nickel-plated carbon fiber film is further reinforced, so that the nickel-plated carbon fiber film not only has the better mechanical property and physical property, but also has the better electromagnetic shielding effectiveness.

### Brief Description of the Drawings

The drawings of the description for forming a part of the present disclosure are used for providing further understanding to the present disclosure, the schematic embodiments and the description thereof of the present disclosure are used for explaining the present disclosure, and not intend to form inappropriate limitation to the present disclosure. In the drawings:
Fig. 1 shows a structure schematic diagram of a nickel-plated carbon fiber film provided according to one embodiment of the present disclosure;
Fig. 2 shows an enlarged schematic diagram of a local structure in Fig. 1 under an electron microscope; and
Fig. 3 shows a structure schematic diagram of a shielding structure provided by one embodiment of the present disclosure.

Herein, the drawings include the following drawing marks:
1, carbon fiber fabric; 2, metal net; 3, nickel-plated carbon fiber film; 4, permalloy layer; 31, carbon fiber base fabric; 32, metal colloid particles; 33, nickel metal layer; 310, carbon fibers.

### Detailed Description of the Embodiments

It should be indicated that the following detailed description is exemplary, and aims to provide the further description to the present disclosure. Unless otherwise specified, all technical and scientific terms used in the text have the same meaning as general understanding of those of ordinary skill in the art to which the present disclosure belongs.

It is to be noted that the terms used herein are only used for describing a specific implementation mode, and not intend to limit an exemplary implementation mode according to the present disclosure. As used herein, unless otherwise specified in the context, a singular form is also intend to include a plural form, in addition, it should be further understood that while terms "containing" and/or "including" are used in the present description, it indicates that features, processes, operations, devices, components and/or their combinations exist.

It should be understood that while an element (such as a layer, a film, an area, or a substrate) is described to be "on" another element, the element can be directly on the other element, or an intermediate element also exists. In addition, in the description and claims, while it is described that an element is "connected" to another element, the element can be "directly connected" to the other element, or "electrically connected to" the other element through a third element.

As introduced in the background, a nickel-plated carbon fiber film in an existing technology does not have both the better physical and mechanical properties and shielding effectiveness, in order to solve the technical problem, the present disclosure provides a nickel-plated carbon fiber film, a manufacturing method of the nickel-plated carbon fiber film, a shielding structure and a preparation method of the shielding structure.

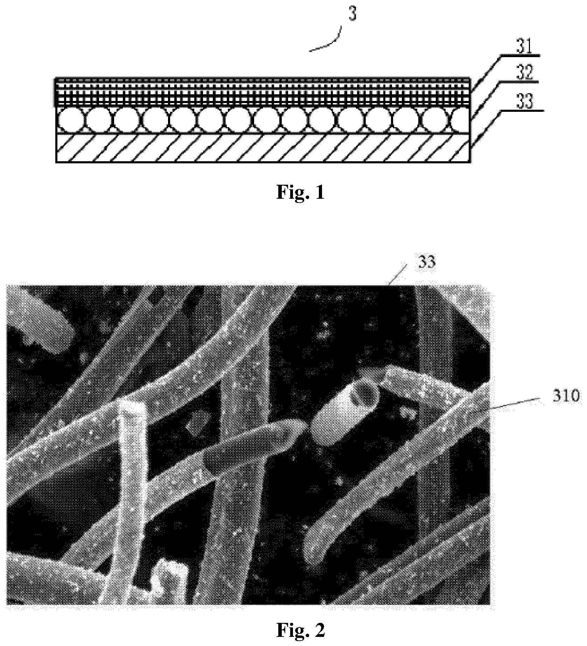

In some embodiments of the present disclosure, a nickel-plated carbon fiber film is provided. As shown in Fig. 1, the nickel-plated carbon fiber film includes at least one carbon fiber base fabric 31 and at least one nickel metal layer 33, metal colloid particles 32 are adhered to a surface of the carbon fiber base fabric 31, the metal colloid particles are metal particles with an adhesion property; and the nickel metal layer 33 is arranged on a naked surface of the carbon fiber base fabric 31 and a surface, away from the carbon fiber base fabric 31, of the metal colloid particles 32. As shown in a local enlargement schematic diagram of Fig. 2, the nickel metal layer 33 is adhered to carbon fibers 310.

In the nickel-plated carbon fiber film of the present disclosure, the metal colloid particles are adhered to the carbon fiber base fabric, the metal colloid particles have the adhesion property, so that the nickel metal layer is adhered to the carbon fiber base fabric better, the electromagnetic shielding effectiveness of the nickel-plated carbon fiber film is further reinforced, so the nickel-plated carbon fiber film not only has the better mechanical property and physical property, but also has the better electromagnetic shielding effectiveness.

In order to further guarantee that the nickel metal layer is adhered near the metal colloid particles better, and adhered to the carbon fiber base fabric better, thereby the electromagnetic shielding effectiveness of the nickel-plated carbon fiber film is improved, in some embodiments of the present disclosure, the metal colloid particles 32 is Pb colloid particles or Ag colloid particles.

Certainly, the metal colloid particles of the present disclosure are not limited to the two types of the particles, those skilled in the art may select other suitable metal colloid particles according to the practical situation, for example, one or more of copper, nickel or cobalt.

The carbon fiber base fabric of the present disclosure is preferably carbon fiber base fabric after organic matters on the surface are removed by surface treatment, the specific surface treatment may refer to the description about the surface treatment hereinafter.

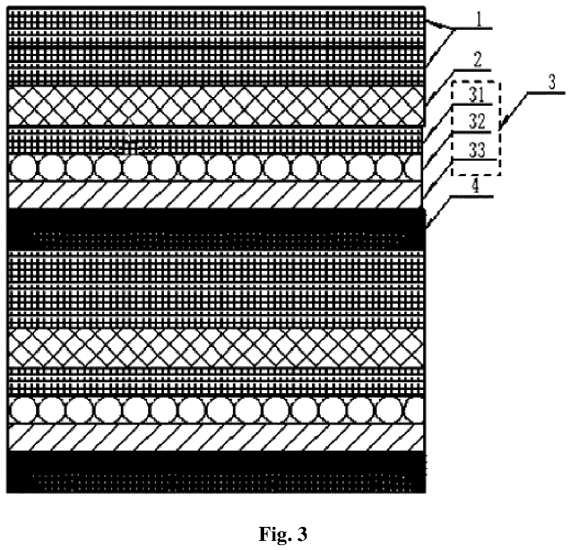

In some another embodiments of the present disclosure, a shielding structure is provided, as shown in Fig. 3, the shielding structure includes at least one shielding component, the shielding component includes any one of the nickel-plated carbon fiber films 3.

Because the shielding structure includes the nickel-plated carbon fiber film 3, the shielding structure has both the better physical and mechanical properties and electromagnetic shielding effectiveness.

In order to further improve the mechanical property and physical property of the shielding component, in some embodiments of the present disclosure, as shown in Fig. 3, the shielding component further includes at least one carbon fiber fabric 1, the nickel-plated carbon fiber film 3 is arranged on a side surface of the carbon fiber fabric 1.

In order to further improve the mechanical property and physical property of the shielding component and simultaneously further guarantee that the shielding component has the better electromagnetic shielding effectiveness, in some embodiments of the present disclosure, a thickness of one of the carbon fiber fabric is between 0.13 and 1.0 mm, or a total thickness of a plurality of the carbon fiber fabric is between 0.13 and 1.0 mm.

In order to conveniently enable the shielding component to be electrically connected with other electrical units, in some embodiments of the present disclosure, as shown in Fig. 3, the shielding component further includes at least one metal net 2, the metal net 2 is arranged between the nickel-plated carbon fiber film 3 and the carbon fiber fabric 1.

In order to improve conductivity of the metal net, and guarantee light weight of the shielding component, in some embodiments of the present disclosure, preferably the metal net 2 is a copper net.

In order to further guarantee electrical connection performance and other performance of the shielding component, in some embodiments of the present disclosure, a thickness of the metal net 2 is between 0.005 and 0.015 mm. It can be further guaranteed that the shielding component may not cause a layering defect for different thermal expansion coefficients between metal and carbon fiber while formed.

In order to further guarantee that the shielding component may not cause the layering defect for different thermal expansion coefficients between metal and carbon fiber while formed, in some embodiments of the present disclosure, as shown in Fig. 3, the shielding component further includes at least one permalloy layer 4, the permalloy layer 4 is arranged on a surface, away from the metal net 2, of the nickel-plated carbon fiber film 3.

In some other embodiments of the present disclosure, a thickness of the permalloy layer 4 is between 0.05 and 0.20 mm, so it can be further guaranteed that the shielding component may not cause the layering defect for different thermal expansion coefficients between metal and carbon fiber while formed.

In order to further guarantee that the shielding component has the better mechanical, physical properties and electromagnetic shielding effectiveness, in some embodiments of the present disclosure, the shielding component includes a plurality of stacked nickel-plated carbon fiber films 3, and a total thickness of the a plurality of the nickel-plated carbon fiber films 3 is between 0.7 and 1.2 mm.

In some other embodiments of the present disclosure, the shielding structure includes a plurality of the shielding components, the a plurality of the shielding components are lamination-arranged, the shielding structure further includes at least one adhesive layer, the adhesive layer is arranged between any adjacent two of the shielding components and between any adjacent two of structure layers in each of the shielding components, and used for bonding the different structure layers.

A material of the adhesive layer can be any one usable adhesive in an existing technology, those skilled in the art may select the suitable adhesive according to the practical situation.

In some embodiments of the present disclosure, a raw material of the adhesive layer includes 80-120 parts by weight of epoxy resin, 60-80 parts by weight of curing agent, and 0.5-2.5 parts by weight of accelerant. The adhesive may further guarantee fastness of bonding between the structure layers.

In order to further improve a curing rate and a curing effect of the adhesive, in some embodiments of the present disclosure, the curing agent is methyl tetrahydrophthalic anhydride, and the accelerant is boron trifluoride ethylamine.

In some other embodiment of the present disclosure, a manufacturing method of a nickel-plated carbon fiber film is provided, the manufacturing method includes: step S1, at least one carbon fiber base fabric is provided; step S3, metal colloid particles are arranged on the carbon fiber base fabric; and step S4, a nickel metal layer is arranged on a naked surface of the carbon fiber base fabric and a surface, away from the carbon fiber base fabric, of the metal colloid particles.

In the manufacturing method of the nickel-plated carbon fiber film, firstly the metal colloid particles are arranged on the carbon fiber base fabric, the metal colloid particles have an adhesion property, and the nickel metal layer is arranged on the surface of the carbon fiber base fabric and the surface, away from the carbon fiber base fabric, of the metal colloid particles, the nickel metal layer is adhered to the carbon fiber base fabric better through the adhesion property of the metal colloid particles, and the electromagnetic shielding effectiveness of the nickel-plated carbon fiber film is further reinforced, so the nickel-plated carbon fiber film not only has the better mechanical property and physical property, but also has the better electromagnetic shielding effectiveness.

In order to further improve the mechanical property, the physical property and the electromagnetic shielding effectiveness, in some embodiments of the present disclosure, the manufacturing method further includes step S2, surfaces of the carbon fiber base fabric is treated, as to remove organic matters on the surface of the carbon fiber base fabric. These organic matters are a protecting material and/or a sizing agent and the like on the carbon fiber base fabric.

In some specific embodiments, the step S2 includes the following steps: the carbon fiber base fabric is soaked with acetone, and a part of the organic matters on the carbon fiber base fabric can be removed; the carbon fiber base fabric soaked with the acetone is soaked with mixed solution of a hydrofluoric acid and a strong acid, and fluorine ions of the hydrofluoric acid can react with the organic matters on the carbon fiber base fabric, thereby these organic matters are removed, and adhesion ability of the carbon fiber base fabric can be improved through realizing chemical coarsening, activity of the fluorine ions can be enhanced by the strong acid solution, and the fluorine ions are enabled to react with the organic matters more adequately; and the soaked carbon fiber base fabric is washed with water, the residual mixed solution is removed by the clear water, as to avoid the mixed solution from affecting a carbon fiber base fabric body and other structures arranged on the carbon fibers subsequently.

The strong acid solution in the step S2 can be any one type of the strong acid solution in an existing technology or mixed by two types of the strong acid solution, the strong acid solution is a sulfuric acid, a hydrochloric acid or a nitric acid, those skilled in the art may select the suitable strong acid solution to be mixed with hydrofluoric acid solution according to the practical situation.

In order to enhance the activity of the fluorine ions in the hydrofluoric acid better, in some embodiments of the present disclosure, a molar ratio of the hydrofluoric acid and the strong acid is between 1:3 and 1:1.

In some other embodiments of the present disclosure, volume concentration of the mixed solution is between 5% and 15%, so that the organic matters on the carbon fiber base fabric can be removed better and other structures of the carbon fiber base fabric are not affected.

In order to guarantee the removing effect of the organic matters, and guarantee that the other structures of the carbon fiber base fabric are not affected, in some embodiments of the present disclosure, in the step S2, a time of soaking the carbon fiber base fabric with the mixed solution is between 5 and 30 min.

In order to remove a part of the organic matters on the carbon fiber base fabric in advance, in some embodiments of the present disclosure, in the step S2, a time of soaking the carbon fiber base fabric with the acetone is between 20 and 40 min.

In some other embodiments of the present disclosure, the step S3 includes: step S31, the carbon fiber base fabric is soaked with a dilute acid solution of a reducing metal salt, namely sensitization is performed, so that a layer of a reducing liquid film with a reduction function is formed on the carbon fiber base fabric; and step S32, activating treatment is performed on the carbon fiber base fabric treated in the step S31 with a dilute acid solution of an oxidizing metal salt, so that reducing metal salt is enabled to perform a reduction reaction with oxidizing metal salt, and metal in the oxidizing metal salt is replaced out, as to generate an activity center, namely the metal colloid particles are generated.

A selection requirement of the oxidizing metal salt is that the corresponding metal is beneficial to smooth nickel plating of the following working procedures. A requirement of the reducing metal salt is that the reducing metal salt may react with the oxidizing metal salt, and other impurity ions are not introduced. Those skilled in the art may select the suitable reducing metal salt and reducing metal salt according to the requirements.

In some embodiments, the oxidizing metal salt is PdCl₂ or AgNO₃, the two parties can guarantee that a reduction-generated metal elementary substance has a certain adhesion property, namely the obtained metal colloid particles have the better adhesion property, so that the nickel metal layer can be further adhered to the carbon fiber base fabric better.

In some embodiments of the present disclosure, the oxidizing metal salt is PdCl₂, Pd can be reduced well by the reducing agent and deposited on the surface of the carbon fiber base fabric so as to form an activating point, subsequently-plated nickel uses the activating point as a center, and the nickel metal layer is formed from point to surface.

In order to reduce the oxidizing metal salt better without introducing other impurities, in some embodiments of the present disclosure, the reducing metal salt is SnCl₂, the SnCl₂ can keep reducing capacity thereof for a longer time in a certain condition, and control a speed of a reduction reaction thereof.

The dilute acid solution in the step S31 can be any one type of the acid solution in an existing technology, only if it does not react with the SnCl₂ and the structure of the carbon fiber base fabric is not affected, an effect thereof is to enhance activity of Sn<2+>. Similarly, the dilute acid solution in the step S32 can be any one type of the acid solution in the existing technology, only if it does not react with the SnCl₂ and the structure of the carbon fiber base fabric is not affected, an effect thereof is to enhance activity of Pd<2+>.

In some embodiments of the present disclosure, the dilute acid solution in the step S31 is a first hydrochloric acid solution, and in the first hydrochloric acid solution, a mass concentration of the SnCl₂ is between 4% and 8%, so it can be further guaranteed that other impurity ions are not introduced in the dilute acid solution, and activity of Sn<2+> can be reinforced better.

In order to further guarantee that a layer of a reducing liquid film is formed on the surface of the carbon fiber base fabric, and a subsequent oxidation reduction reaction is more advantageously performed, thereby subsequent nickel plating is more advantageously performed, in some embodiments of the present disclosure, a soaking temperature of the step S31 is between 25 and 40ºC, and soaking time is 20-50 min.

In another embodiment of the present disclosure, the oxidizing metal salt is PdCl₂, the dilute acid solution in the step S32 is a second hydrochloric acid solution, and in the second hydrochloric acid solution, a mass concentration of the PdCl₂ is between 0.02% and 0.04%. So it can be further guaranteed that other impurity ions are not introduced in the dilute acid solution, and activity of Pd<2+> can be better reinforced.

In order to further guarantee that the activating process has the better activating effect, in some embodiments of the present disclosure, a temperature of the dilute acid solution of the PdCl₂ is between 25 and 40ºC, and a time of the activating treatment is 10-50 min.

In some other embodiments of the present disclosure, after the carbon fiber base fabric is soaked with the dilute acid solution of SnCl₂, the step S31 further includes the following steps: the carbon fiber base fabric is washed with water, so that an acid in the dilute acid solution of the SnCl₂ physically adsorbed on the carbon fiber base fabric is mainly removed, and the acid is prevented from causing an adverse effect to the structure of the carbon fiber base fabric.

In order to further remove the dilute acid solution of PdCl₂ physically adsorbed on the carbon fiber base fabric, in some embodiments of the present disclosure, the oxidation metal salt is the PdCl₂, after the activating treatment is performed on the carbon fiber base fabric with the dilute acid solution of the PdCl₂, the step S32 further includes the following steps: the carbon fiber base fabric is washed with water.

In some other embodiments of the present disclosure, the step S4 includes the following steps: a plating solution is adopted, and the nickel metal layer is arranged with an electroless nickel plating, electromagnetic function reinforcement is performed on the surface of the carbon fiber base fabric, eddy current loss is generated to an electromagnetic wave with conductivity of nickel, and consumption is performed on the electromagnetic wave with a ferromagnetic property of the nickel. So a nickel metal layer formed by such electroless nickel plating is more uniform and compact, it is further guaranteed that the nickel metal layer has the better electromagnetic shielding effectiveness, and guaranteed that the nickel-plated carbon fiber film has the better electromagnetic shielding effectiveness and mechanical and physical properties.

In order to form the more compact and uniform nickel metal layer, and guarantee that a forming speed of the nickel metal layer is rapider, in some embodiments of the present disclosure, the plating solution includes 40-60 parts by weight of nickel salt, 40-60 parts by weight of reducing agent, 80-120 parts by weight of complexing agent, 40-60 parts by weight of buffering agent and 0.15-0.25 parts by weight of surfactant.

In order to further improve a deposition rate of the nickel metal, in some embodiments of the present disclosure, a pH value of the plating solution is 10-11.

The nickel salt in the plating solution can be any one type of usable nickel salt in an existing technology, those skilled in the art may select the suitable nickel salt according to the practical situation, for example nickel chloride, nickel acetate or nickel sulfate and the like can be selected.

The reducing agent in the plating solution can be any reducing agents capable of reducing the nickel salt in an existing technology, those skilled in the art can select the suitable reducing agent according to the practical situation, for example sodium borohydride, borane or sodium hypophosphite can be selected.

The complexing agent in the plating solution can be any usable complexing agents in an existing technology, those skilled in the art can select the suitable complexing agent according to the practical situation, for example acetate, glycinate or citrate can be selected.

The buffering agent in the present disclosure can be any usable buffering agents for chemical nickel-plating in an existing technology, those skilled in the art can select the suitable buffering agent according to the practical situation, for example boric acid or ammonium chloride can be selected.

The surfactant in the present disclosure can be any usable surfactants for chemical nickel-plating in an existing technology, those skilled in the art can select the suitable surfactant according to the practical situation, for example polyethylene glycol, Tween or sodium dodecyl benzene sulfonate can be selected.

In order not to introduce other impurity ions, and in order to enable a reaction process of the chemical nickel-plating to be more stable so that the obtained metal nickel layer is more compact and uniform, in some embodiments of the present disclosure, the nickel salt includes the nickel sulfate, the reducing agent includes the sodium hypophosphite, the complexing agent includes the sodium citrate, the buffering agent includes the ammonium chloride, and the surfactant includes the sodium dodecyl benzene sulfonate.

In order to further improve the reaction rate and avoid performing a side reaction, in some embodiments of the present disclosure, a temperature of the plating solution is between 40 and 60ºC.

In order to enable a reaction of the chemical nickel-plating to be more adequately performed and guarantee that the obtained nickel metal layer is more compact, in some embodiments of the present disclosure, an implementation time of the electroless nickel plating is between 20 and 50 min.

In some other embodiment of the present disclosure, a preparation method of a shielding structure is provided, the preparation method includes a manufacturing process of at least one shielding component, and the manufacturing process includes a manufacturing method of any one of the nickel-plated carbon fiber films.

Because the preparation method includes the manufacturing method, efficiency of the preparation method is higher and the obtained shielding structure has the better mechanical, physical properties and electromagnetic shielding effectiveness.

In some other embodiments of the present disclosure, the manufacturing process further includes the following steps: a carbon fiber fabric is provided; and at least one metal net and the nickel plated carbon fiber film are successively superposition-arranged on the carbon fiber fabric. The carbon fiber fabric is arranged so that mechanical property and physical property of the shielding component can be further improved, and the metal net is arranged so that the shielding component is conveniently electrically connected with other electrical units. Such obtained shielding component has the better mechanical property and physical property, and through using a shielding principle of a plurality of structure layers, and using the structure layers of different electrical property mediums, it is realized that a material has the excellent electromagnetic shielding effectiveness in a wider frequency band through a design of the different structure layers.

In order to improve conductivity of the metal net, and guarantee light weight of the shielding component, in some embodiments of the present disclosure, preferably the metal net is a copper net.

In order to further guarantee that the shielding component can not cause a layering defect because of different metal and carbon fiber thermal expansion coefficients while formed, in some embodiments of the present disclosure, the manufacturing process further includes the following step: at least one permalloy layer is arranged on a surface, away from the metal net, of the nickel-plated carbon fiber film.

In order to improve reliability and fastness of bonding of each layer of the shielding structure, in some embodiments of the present disclosure, the preparation method further includes the following steps: hot pressing is performed on the pre-shielding component or the hot pressing is performed on a plurality of stacked pre-shielding components, as to form the shielding structure.

In some embodiments, a process of the hot pressing includes the following steps: an adhesive is arranged between the adjacent structure layers to be hot pressed, and a pre-hot press structure is formed, while the shielding structure only includes one shielding component, the adhesive is only needed to be arranged between the structure layers in the pre-shielding component, and while the shielding structure includes a plurality of shielding components, and the adhesive is also needed to be arranged between two shielding components; pressing is performed on the pre-hot press structure; and curing is performed on the adhesive in the pre-hot press structure after the pressing. The structure layer of the present disclosure is single carbon fiber fabric, metal net, permalloy layer or nickel-plated carbon fiber film.

A specific process of the adhesive installation may include the following steps: each component of the adhesive is firstly adequately stirred, dispersed and mixed, the carbon fiber fabric and the nickel-plated carbon fiber film and the permalloy layer are measured and dipped, and the metal net is coated.

The adhesive used in the hot pressing can be any one usable adhesive in an existing technology, those skilled in the art may select the suitable adhesive according to the practical situation.

In some other embodiments of the present disclosure, the adhesive used in the hot pressing includes 80-120 parts by weight of epoxy resin, and the epoxy resin is less in volatile matter, and good in stability in a room temperature; 60-80 parts by weight of curing agent, and 0.5-2.5 parts by weight of accelerant. The adhesive may further guarantee the fastness of bonding between the structure layers.

In order to further improve a curing rate and a curing effect of the adhesive, in some embodiments of the present disclosure, the curing agent is methyl tetrahydrophthalic anhydride, and the accelerant is boron trifluoride ethylamine.

A pressure of the pressing is between 0.4 and 0.8 MPa. So it can be better guaranteed that the formed shielding structure has the better fastness.

The curing can be heat curing, or can be light curing, those skilled in the art may select a specific curing type according to the practical situation, for example a type of the specific adhesive.

In some embodiments of the present disclosure, the curing is heat curing, and preferably a temperature of the heat curing is between 120 and 150ºC; and a time of the heat curing is between 1 and 3 h. So the adhesive can be cured better, and each structure layer is bonded better, thereby the shielding structure has the better bonding strength.

The water in the present disclosure can be deionized water, distilled water or tap water and the like. Those skilled in the art may select the suitable water according to the practical situation.

In order to make those skilled in the art more clearly understand a technical scheme of the present disclosure, the technical scheme of the present disclosure is described in combination with the specific embodiments below.

### Embodiment 1

A manufacturing process of a shielding structure includes the following steps:
Each of a plurality of carbon fiber base fabrics (a shop sign is 3k, t700, and 200 g of surface density) is soaked for 30 min in acetone, after the surface of the carbon fiber base fabric is washed with distilled water, the carbon fiber base fabric is soaked for 10 min in 10% (volume concentration) mixed dilute solution of which a molar ratio of HF and H₂SO₄ is 4:6, and washed with the distilled water; the carbon fiber base fabric is treated for 30 min with diluted HCI acid solution, mass concentration of SnCl₂ in the diluted HCI acid solution is 5%, and a temperature of the diluted HCI acid solution of the SnCl₂ is 30ºC (namely a soaking temperature), and the carbon fiber base fabric is washed with the distilled water; and activating treatment is performed on the carbon fiber base fabric with 0.025% (mass ratio) of dilute acid solution of PdCl₂, treatment time is 20 min, and a temperature of the dilute acid solution of the PdCl₂ is 30ºC (namely the soaking temperature), two types of the dilute acid solution are diluted hydrochloric acid solution.

Plating solution includes 50 parts by weight of nickel sulfate, 50 parts by weight of sodium hypophosphite, 100 parts by weight of sodium citrate, 50 parts by weight of mmonium chloride and 0.2 parts by weight of sodium dodecyl benzene sulfonate, and a pH value of the plating solution is adjusted to be between 10 and 11 with sodium hydroxide, the plating solution is heated to 45° C of a temperature, a nickel metal layer is deposited on a surface of the carbon fiber base fabric after surface treatment with the plating solution, treatment time is 30 min, and a nickel-plated carbon fiber film is obtained.

Layer laying is performed in a mould in the following structure, a first layer is three carbon fiber fabric of which a total thickness is 0.54 mm (a shop sign of each carbon fiber fabric is 3k, t700, and 200 g of surface density, and a thickness of each carbon fiber fabric is 0.18 mm), a second layer is 150 meshes of a copper net of which a thickness is 0.01 mm, a third layer is five nickel-plated carbon fiber films of which a total thickness is 0.9 mm (a thickness of each nickel-plated carbon fiber film is 0.18 mm), and a fourth layer is at least one permalloy layer of which a thickness is 0.1 mm (a shop sign is 1J50), a pre-shielding component is formed; and the layer laying process is repeated for 6 times.

100 parts by weight of epoxy resin, 70 parts by weight of methyl tetrahydrophthalic anhydride curing agent and 1.5 parts by weight of boron trifluoride ethylamine accelerant are successively added to a mixer for mixing and adequately stirred and dispersed. After dipping or coating on each structure is measured, each structure is placed in the mould for laminating, and a pressure is 0.6 MPa; after that, curing is performed, and a curing temperature is 135ºC; and curing time is 1.5 h, a shielding structure is obtained after demoulding.

### Embodiment 2

Each of a plurality of carbon fiber base fabrics (a shop sign is 6k, t700, and 300 g of surface density) is soaked for 30 min in acetone, after the surface of the carbon fiber base fabric is washed with distilled water, the carbon fiber base fabric is soaked for 10 min in 10% mixed dilute solution of which a molar ratio of HF and H₂SO₄ is 4:6, and washed with the distilled water; the carbon fiber base fabric is treated for 30 min with diluted HCI acid solution, mass concentration of SnCl₂ in the diluted HCI acid solution is 5%, and a temperature of the diluted HCI acid solution of the SnCl₂ is 30ºC (namely a soaking temperature), and the carbon fiber base fabric is washed with the distilled water; and activating treatment is performed on the carbon fiber base fabric by 0.025% (mass ratio) of dilute acid solution of PdCl₂, treatment time is 20 min, and a temperature of the dilute acid solution of the PdCl₂ is 30ºC (namely the soaking temperature), two types of the dilute acid solution are diluted hydrochloric acid solution.

Plating solution includes 50 parts by weight of nickel sulfate, 50 parts by weight of sodium hypophosphite, 100 parts by weight of sodium citrate, 50 parts by weight of mmonium chloride and 0.2 parts by weight of sodium dodecyl benzene sulfonate, and a pH value of the plating solution is between 10 and 11, and a temperature is 45ºC, a nickel metal layer is deposited on a surface of the carbon fiber base fabric after surface treatment with the plating solution, treatment time is 30 min, and a nickel-plated carbon fiber film is obtained.

Layer laying is performed in a mould in the following structure, a first layer is three carbon fiber fabric of which a total thickness is 0.54 mm (a shop sign of each carbon fiber fabric is 6k, t700, and 300 g of surface density, and a thickness of each carbon fiber fabric is 0.18 mm), a second layer is 150 meshes of a copper net of which a thickness is 0.01 mm, a third layer is nine nickel-plated carbon fiber films of which a total thickness is 1.17 mm (a thickness of each nickel-plated carbon fiber film is 0.13 mm), and a fourth layer is at least one permalloy layer of which a thickness is 0.1 mm (a shop sign is 1J50), a pre-shielding component is formed; and the layer laying process is repeated for 5 times.

100 parts by weight of epoxy resin, 80 parts by weight of methyl tetrahydrophthalic anhydride curing agent and 1.5 parts by weight of boron trifluoride ethylamine accelerant are successively added to a mixer for mixing and adequately stirred and dispersed. After dipping or coating on each structure is measured, each structure is placed in the mould for laminating, and a pressure is 0.6 MPa; after that, curing is performed, and a curing temperature is 135ºC; and curing time is 1.5 h, a shielding structure is obtained after demoulding.

### Embodiment 3

A manufacturing process of a shielding structure includes the following steps:
Each of a plurality of carbon fiber base fabrics (a shop sign is 3k, t700, and 200 g of surface density) is soaked for 10 min in acetone, after the surface of the carbon fiber base fabric is washed with distilled water, the carbon fiber base fabric is soaked for 30 min in 15% mixed dilute solution of which a molar ratio of HF and H₂SO₄ is 1:3, and washed with the distilled water; the carbon fiber base fabric is treated for 20 min with diluted HCI acid solution, mass concentration of SnCl₂ in the diluted HCI acid solution is 8%, and a temperature of the diluted HCI acid solution of the SnCl₂ is 40ºC (namely a soaking temperature), and the carbon fiber base fabric is washed with the distilled water; and activating treatment is performed on the carbon fiber base fabric by 0.04% (mass ratio) of dilute acid solution of PdCl₂, treatment time is 10 min, and a temperature of the dilute acid solution of the PdCl₂ is 40ºC (namely the soaking temperature), two types of the dilute acid solution are diluted hydrochloric acid solution.

Plating solution includes 40 parts by weight of nickel sulfate, 40 parts by weight of sodium hypophosphite, 80 parts by weight of sodium citrate, 40 parts by weight of mmonium chloride and 0.15 parts by weight of sodium dodecyl benzene sulfonate, and a pH value of the plating solution is between 10 and 11 (the same as Embodiment 1, sodium hydroxide is used for adjusting), a temperature is 60ºC (the same as Embodiment 1, heated to the temperature), a nickel metal layer is deposited on a surface of the carbon fiber base fabric after surface treatment with the plating solution, treatment time is 50 min, and a nickel-plated carbon fiber film is obtained.

Layer laying is performed in a mould in the following structure, a first layer is carbon fiber fabric (a shop sign of sub-carbon fiber fabric is 3k, t700, and 200 g of surface density) of which a thickness is 0.13mm (actually including one carbon fiber fabric), a second layer is 150 meshes of a copper net of which a thickness is 0.005 mm, a third layer is four nickel-plated carbon fiber films of which a total thickness is 0.72 mm (a thickness of each nickel-plated carbon fiber film is 0.18 mm), and a fourth layer is at least one permalloy layer of which a thickness is 0.05 mm (a shop sign is 1J50), a pre-shielding component is formed; and the layer laying process is repeated for 7 times.

80 parts by weight of epoxy resin, 60 parts by weight of methyl tetrahydrophthalic anhydride curing agent and 0.5 parts by weight of boron trifluoride ethylamine accelerant are successively added to a mixer for mixing and adequately stirred and dispersed. After dipping or coating on each structure is measured, each structure is placed in the mould for laminating, and a pressure is 0.8 MPa; after that, curing is performed, and a curing temperature is 120ºC; and curing time is 3 h, a shielding structure is obtained after demoulding.

### Embodiment 4

A manufacturing process of a shielding structure includes the following steps:
Each of a plurality of carbon fiber base fabrics (a shop sign is 3k, t700, and 200 g of surface density) is soaked for 50 min in acetone, after the surface of the carbon fiber base fabric is washed with distilled water, the carbon fiber base fabric is soaked for 5 min in 5% mixed dilute solution of which a molar ratio of HF and H₂SO₄ is 1:1, and washed with the distilled water; the carbon fiber base fabric is treated for 50 min by diluted HCI acid solution, mass concentration of SnCl₂ in the diluted HCI acid solution is 4%, and a temperature of the diluted HCI acid solution of the SnCl₂ is 25ºC (namely a soaking temperature), and the carbon fiber base fabric is washed with the distilled water; and activating treatment is performed on the carbon fiber base fabric by 0.02% (mass ratio) of dilute acid solution of PdCl₂, treatment time is 50 min, and a temperature of the dilute acid solution of the PdCl₂ is 25ºC (namely the soaking temperature), two types of the dilute acid solution are diluted hydrochloric acid solution.

Plating solution includes 60 parts by weight of nickel sulfate, 60 parts by weight of sodium hypophosphite, 120 parts by weight of sodium citrate, 60 parts by weight of mmonium chloride and 0.25 parts by weight of sodium dodecyl benzene sulfonate, and a pH value of the plating solution is between 10 and 11 (the same as Embodiment 1, sodium hydroxide is used for adjusting), a temperature is 40ºC (the same as Embodiment 1, heated to the temperature), a nickel metal layer is deposited on a surface of the carbon fiber base fabric after surface treatment with the plating solution, treatment time is 20 min, and a nickel-plated carbon fiber film is obtained.

Layer laying is performed in a mould in the following structure, a first layer is five carbon fiber fabric (a shop sign of the carbon fiber fabric is 3k, t700, and 200 g of surface density, and a thickness of each nickel-plated carbon fiber film is 0.18 mm) of which a total thickness is 0.9mm, a second layer is 150 meshes of a copper net of which a thickness is 0.015 mm, a third layer is five nickel-plated carbon fiber films of which a total thickness is 0.9 mm (a thickness of each nickel-plated carbon fiber film is 0.18 mm), and a fourth layer is at least one permalloy layer of which a thickness is 0.2 mm (a shop sign is 1J50), a pre-shielding component is formed; and the layer laying process is repeated for 6 times.

120 parts by weight of epoxy resin, 80 parts by weight of methyl tetrahydrophthalic anhydride curing agent and 2.5 parts by weight of boron trifluoride ethylamine accelerant are successively added to a mixer for mixing and adequately stirred and dispersed. After dipping or coating on each structure is measured, each structure is placed in the mould for laminating, and a pressure is 0.8 MPa; after that, curing is performed, and a curing temperature is 150ºC; and curing time is 1 h, a shielding structure is obtained after demoulding.

### Embodiment 5

A difference with embodiment 1 is that: HF:H₂SO₄=6:5(molar ratio).

### Embodiment 6

A difference with embodiment 1 is that: volume concentration of HF and H₂SO₄ in mixed dilute solution is 4%.

### Embodiment 7

A difference with embodiment 1 is that: time of soaking carbon fiber base fabric by mixed dilute solution of HF and H₂SO₄ is 3 min.

### Embodiment 8

A difference with embodiment 1 is that: in diluted HCI acid solution of SnCl₂, mass concentration of the SnCl₂ is 3%.

### Embodiment 9

A difference with embodiment 1 is that: a temperature of diluted HCI acid solution of SnCl₂ is 20ºC.

### Embodiment 10

A difference with embodiment 1 is that: treatment time of diluted HCI acid solution of SnCl₂ to carbon fiber base fabric is 10 min.

### Embodiment 11

A difference with embodiment 1 is that: in dilute acid solution of PdCl₂, mass concentration of the PdCl₂ is 0.01%.

### Embodiment 12

A difference with embodiment 1 is that: a temperature of diluted HCl acid solution of PdCl₂ is 20ºC.

### Embodiment 13

A difference with embodiment 1 is that: treatment time of diluted HCI acid solution of PdCl₂ to carbon fiber base fabric is 5 min.

### Embodiment 14

A difference with embodiment 1 is that: nickel sulfate in plating solution is 30 parts by weight.

### Embodiment 15

A difference with embodiment 1 is that: sodium hypophosphite in plating solution is 30 parts by weight.

### Embodiment 16

A difference with embodiment 1 is that: sodium citrate in plating solution is 70 parts by weight.

### Embodiment 17

A difference with embodiment 1 is that: ammonium chloride in plating solution is 30 parts by weight.

### Embodiment 18

A difference with embodiment 1 is that: sodium dodecyl benzene sulfonate in plating solution is 0.1 parts by weight.

### Embodiment 19

A difference with embodiment 1 is that: a pH value of plating solution is between 8 and 9.

### Embodiment 20

A difference with embodiment 1 is that: a temperature of plating solution is 30ºC.

### Embodiment 21

A difference with embodiment 1 is that: treatment time of chemical nickel-plating is 10 min.

### Embodiment 22

A difference with embodiment 1 is that: epoxy resin in an adhesive is 70 parts by weight.

### Embodiment 23

A difference with embodiment 1 is that: a curing agent in an adhesive is 50 parts by weight.

### Embodiment 24

A difference with embodiment 1 is that: an accelerant in an adhesive is 0.3 parts by weight.

### Embodiment 25

A difference with embodiment 1 is that: a curing temperature of an adhesive is 110ºC.

### Embodiment 26

A difference with embodiment 1 is that: curing time of an adhesive is 5 h.

### Embodiment 27

A difference with embodiment 1 is that: a pressure of lamination is 0.3 MPa.

### Embodiment 28

A difference with embodiment 1 is that: a thickness of a cupper net is 0.1 mm.

### Embodiment 29

A difference with embodiment 1 is that: a thickness of at least one permalloy layer is 0.4 mm.

### Contrast example

Each of a plurality of carbon fiber base fabrics (a shop sign is 3k, t700, and 200 g of surface density) is soaked for 30 min in acetone, after the surface of the carbon fiber base fabric is washed with distilled water, the carbon fiber base fabric is soaked for 10 min in 10% (volume concentration) mixed dilute solution of which a molar ratio of HF and H₂SO₄ is 4:6, and washed with the distilled water.

Plating solution includes 50 parts by weight of nickel sulfate, 50 parts by weight of sodium hypophosphite, 100 parts by weight of sodium citrate, 50 parts by weight of mmonium chloride and 0.2 parts by weight of sodium dodecyl benzene sulfonate, and is heated to 45ºC, and a pH value of the plating solution is adjusted to be between 10 and 11 with sodium hydroxide, a nickel metal layer is deposited on a surface of the carbon fiber base fabric after surface treatment with the plating solution, treatment time is 30 min, and a nickel-plated carbon fiber film is obtained.

Layer laying is performed in a mould in the following structure, a first layer is three carbon fiber fabric of which a total thickness is 0.54 mm (a shop sign of each carbon fiber fabric is 3k, t700, and 200 g of surface density, and a thickness of each carbon fiber fabric is 0.18 mm), a second layer is 150 meshes of a copper net of which a thickness is 0.01 mm, a third layer is five nickel-plated carbon fiber films of which a total thickness is 0.9 mm (a thickness of each nickel-plated carbon fiber film is 0.18 mm), and a fourth layer is at least one permalloy layer of which a thickness is 0.1 mm (a shop sign is 1J50), a pre-shielding component is formed; and the layer laying process is repeated for 6 times.

100 parts by weight of epoxy resin, 70 parts by weight of methyl tetrahydrophthalic anhydride curing agent and 1.5 parts by weight of boron trifluoride ethylamine accelerant are successively added to a mixer for mixing and adequately stirred and dispersed. After dipping or coating on each structure is measured, each structure is placed in the mould for laminating, and a pressure is 0.6 MPa; after that, curing is performed, and a curing temperature is 135ºC; and curing time is 1.5 h, a shielding structure is obtained after demoulding.

Each embodiment is tested by using a GB/T1447-2005 fiber reinforced plastic tensile property testing method and tensile strength of the shielding structure in proportion is tested, and each embodiment is tested by using a GB/T12190-2006 electromagnetic shielding chamber shielding effectiveness testing method and the shielding effectiveness of the shielding structure in proportion is tested, a specific testing result is shown in Table 1

**Table 1**

| | Tensile strength (MPa) | Shielding effectiveness (dB) |
|---|---|---|
| Embodiment 1 | ≥600 | SE_{14kHz}≥60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 2 | ≥600 | SE_{14kHz}≥60; SE_{150kHz}≥65; SE_{30MHz}≥75; SE_{200MHz}≥70; SE_{950MHz}≥SE_{3GHz}≥85; SE_{6GHz}≥90; SE_{10GHz}≥80; SE_{18GHz}≥65 |
| Embodiment 3 | ≥550 | SE_{14kHz}≥62; SE_{150kHz}≥62; SE_{30MHz}≥75; SE_{200MHz}≥75; SE_{950MHz}≥75; SE_{3GHz}≥90; SE_{6GHz}≥90; SE_{10GHz}≥80; SE_{18GHz}≥70 |
| Embodiment 4 | ≥520 | SE_{14kHz}≥60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 5 | ≥500 | SE_{14kHz}≥60; SE_{150kHz}≥55; SE_{30MHz}≥65; SE_{200MHz}≥65; SE_{950MHz}≥70; SE_{3GHz}≥90; SE_{6GHz}≥90; SE_{10GHz}≥80; SE_{18GHz}≥70 |
| Embodiment 6 | ≥500 | SE_{14kHz}≥60; SE_{150kHz} ≥55; SE_{30MHz}≥65; SE_{200MHz}≥70; SE_{950MHz}≥70; SE_{3GHz}≥90; SE_{6GHz}≥90; SE_{10GHz}≥80; SE_{18GHz}≥70 |
| Embodiment 7 | ≥500 | SE_{14kHz}≥60; SE_{150kHz}≥55; SE_{30MHz}≥65; SE_{200MHz}≥65; SE_{950MHz}≥70; SE_{3GHz}≥90; SE_{6GHz}≥90; SE_{10GHz}≥80; SE_{18GHz}≥70 |
| Embodiment 8 | ≥600 | SE_{14kHz}≥60; SE_{150kHz}≥55; SE_{30MHz}≥65; SE_{200MHz}≥65; SE_{950MHz}70; SE_{3GHz}≥90; SE_{6GHz}≥90; SE_{10GHz}≥80; SE_{18GHz}≥70 |
| Embodiment 9 | ≥600 | SE_{14kHz}≥60; SE_{150kHz}≥55; SE_{30MHz}≥65; SE_{200MHz}≥65; SE_{950MHz}≥70; SE_{3GHz}≥90; SE_{6GHz}≥90; SE_{10GHz}≥80; SE_{18GHz}≥70 |
| Embodiment 10 | ≥550 | SE_{14kHz}≥50; SE_{150kHz}≥50; SE_{30MHz}≥60; SE_{200MHz}≥60; SE_{950MHz}≥65; SE_{3GHz}≥80; SE_{6GHz}≥80; SE_{10GHz}≥80; SE_{18GHz}≥60 |
| Embodiment 11 | ≥550 | SE_{14kHz}≥60; SE_{150kHz}≥55; SE_{30MHz}≥65; SE_{200MHz}≥65; SE_{950MHz}≥70; SE_{3GHz}≥90; SE_{6GHz}≥90; SE_{10GHz}≥80; SE_{18GHz}≥70 |
| Embodiment 12 | ≥550 | SE_{14kHz}≥55; SE_{150kHz}≥55; SE_{30MHz}≥60; SE_{200MHz}≥65; SE_{950MHz}≥70; SE_{3GHz}≥90; SE_{6GHz}≥80; SE_{10GHz}≥80; SE_{18GHz}≥65 |
| Embodiment 13 | ≥600 | SE_{14kHz}≥55; SE_{150kHz}≥55; SE_{30MHz}≥65; SE_{200MHz}≥65; SE_{950MHz} ≥70; SE_{3GHz}≥90; SE_{6GHz}≥80; SE_{10GHz}≥80; SE_{18GHz}≥70 |
| Embodiment 14 | ≥600 | SE_{14kHz}≥55; SE_{150KHz}≥55; SE_{30MHz}≥62; SE_{200MHz}≥62; SE_{950MHz}≥75; SE_{3GHz}≥80; SE_{6GHz}≥85; SE_{10GHz}≥75; SE_{18GHz}≥65 |
| Embodiment 15 | ≥500 | SE_{14kHz}≥55; SE_{150kHz}≥50; SE_{30MHz}≥60; SE_{200MHz}≥60; SE_{950MHz}≥70, SE_{3GHz}≥80; SE_{6GHz}≥80; SE_{10GHz}≥75; SE_{18GHz}≥60 |
| Embodiment 16 | ≥550 | SE_{14kHz}≥55; SE_{15kHz}≥50; SE_{30MHz}≥65; SE_{200MHz}≥60; SE_{950MHz}≥70; SE_{3GHz}≥90; SE_{6GHz}≥90; SE_{10GHz}≥80; SE_{18GHz}≥70 |
| Embodiment 17 | ≥550 | SE_{14kHz}≥55; SE_{150kHz}≥50; SE_{30MHz}≥65; SE_{200MHz}≥60; SE_{950MHz}≥70; SE_{3GHz}≥90; SE_{6GHz}≥90; SE_{10GHz}≥80; SE_{18GHz}≥70 |
| Embodiment 18 | ≥550 | SE_{14kHz}≥55; SE_{150kHz}≥55; SE_{30MHz}≥65; SE_{200MHz}≥70; SE_{950MHz}≥70; SE_{3GHz}≥90; SE_{6GHz}≥90; SE_{10GHz}≥80; SE_{18GHz}≥70 |
| Embodiment 19 | ≥600 | SE_{14kHz}≥55; SE_{150kHz}≥50; SE_{30MHz}≥55; SE_{200MHz}≥60; SE_{950MHz}≥65; SE_{3GHz}≥70; SE_{6GHz}≥80; SE_{10GHz}≥65; SE_{18GHz}≥60 |
| Embodiment 20 | ≥550 | SE_{14kHz}≥50; SE_{150kHz}≥40; SE_{30MHz}≥45; SE_{MHz}≥50; SE_{950MHz}≥55; SE_{3GHz} ≥60; SE_{6GHz}≥70; SE_{10GHz}≥60; SE_{18GHz}≥60 |
| Embodiment 21 | ≥600 | SE_{14kHz}≥55; SE_{150kHz}≥45; SE_{30MHz}≥50; SE_{200MHz}≥55; SE_{150MHz}≥65; SE_{3GHz}≥70; SE_{6GHz}≥80; SE_{10GHz}≥65; SE_{18GHz}≥60 |
| Embodiment 22 | ≥400 | SE_{14Khz}≥60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 23 | ≥400 | SE_{14kHz}≥ 60; SE_{150kHz}≥ 60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 24 | ≥550 | SE_{14kHz}≥ 60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 25 | ≥400 | SE_{14kHz}≥60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 26 | ≥600 | SE_{14kHz}≥60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 27 | ≥550 | SE_{14kHz}≥60; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Embodiment 28 | ≥500 | SE_{14kHz}≥60; SE_{150kHz}≥60; SE_{30MHz}≥70; SE_{200MHz}≥72; SE_{950MHz}≥80; SE_{3GHz}≥90; SE_{6GHz}≥90; SE_{10GHz}≥85; SE_{18GHz}≥72 |
| Embodiment 29 | ≥400 | SE_{14kHz}≥65; SE_{150kHz}≥60; SE_{30MHz}≥70; SE_{200MHz}≥70; SE_{950MHz}≥70; SE_{3GHz}≥90; SE_{6GHz}≥90; SE_{10GHz}≥80; SE_{18GHz}≥70 |
| Contrast example | ≥650 | SE_{14kHz}≥30; SE_{150kHz}≥35; SE_{30MHz}≥45; SE_{200MHz}≥50; SE_{950MHz}≥50; SE_{3GHz}≥55; SE_{6GHz}≥50; SE_{10GHz}≥50; SE_{18GHz}≥45 |

It can be known from the testing result of the table that contrast example is compared with embodiment 1, sensitization and activation processes are not included, so the thickness or an area of the nickel metal layer does not reach a preset range, and shielding effectiveness of the shielding structure is poorer; each embodiment is capable of simultaneously acquiring the better mechanical property and the better shielding effectiveness; compared with embodiment 1, because the molar ratio of hydrofluoric acid and strong acid in a surface treatment process is not between 1:3 and 1:1 in embodiment 5, the surface treatment effect is poorer, and the adhesion force of the nickel metal layer is worsened, thereby the mechanical property of the shielding component is apparently reduced; compared with embodiment 1, because the volume concentration of mixed solution in the surface treatment process is smaller, and is not between 5% and 15% in embodiment 6, the surface treatment effect is poorer, thereby the adhesion force of the nickel metal layer is worsened, and the mechanical property of the shielding component is apparently reduced; compared with embodiment 1, because time of soaking carbon fiber base fabric with mixed solution is shorter in embodiment 7, the surface treatment effect is poorer, thereby the adhesion force of the nickel metal layer is worsened, and the mechanical property of the shielding component is apparently reduced; compared with embodiment 1, because mass concentration of SnCl₂ is smaller in embodiment 8, an activation center is reduced, the formed nickel metal layer is less than a preset area or a preset thickness, namely a plating layer is incomplete, so the shielding effectiveness thereof is reduced to some extent because of the incomplete plating layer; compared with the embodiment 1, because a temperature of SnCl₂ solution is lower in embodiment 9, the shielding effectiveness of the shielding structure is reduced to some extent; compared with embodiment 1, because soaking time of using the SnCl₂ solution is shorter in embodiment 10, the shielding effectiveness and the mechanical property of the shielding structure are reduced to some extent; compared with embodiment 1, because mass concentration of PdCl₂ is smaller in embodiment 11, the shielding effectiveness and the mechanical property of the shielding structure are reduced to some extent; compared with embodiment 1, because the temperature of dilute acid solution of the PdCl₂ is lower in embodiment 12, the shielding effectiveness and the mechanical property of the shielding structure are reduced to some extent; compared with embodiment 1, because the soaking time of the PdCl₂ solution is shorter in embodiment 13, the shielding effectiveness of the shielding structure is reduced to some extent; compared with embodiment 1, because parts by weight of nickel sulfate in plating solution are less in embodiment 14, the thickness or the area of the nickel metal layer does not reach the preset value, and the shielding effectiveness of the shielding structure is reduced to some extent; compared with embodiment 1, because sodium hypophosphite is less in embodiment 15, the shielding effectiveness and the mechanical property of the shielding structure are reduced to some extent; compared with embodiment 1, because a sodium citrate complexing agent is reduced in embodiment 16, the shielding effectiveness and the mechanical property of the shielding structure are reduced to some extent; compared with embodiment 1, because the ammonium chloride buffering agent is reduced in embodiment 17, the shielding effectiveness and the mechanical property of the shielding structure are reduced to some extent; compared with embodiment 1, because the surfactant is reduced in embodiment 18, the shielding effectiveness and the mechanical property of the shielding structure are reduced to some extent; compared with embodiment 1, because the pH value of the plating solution is reduced in embodiment 19, the shielding effectiveness of the shielding structure is reduced to some extent; compared with embodiment 1, because the temperature of the plating solution is reduced in embodiment 20, the shielding effectiveness and the mechanical property of the shielding structure are reduced to some extent; compared with embodiment 1, because nickel-plating time is reduced in embodiment 21, the shielding effectiveness of the shielding structure is reduced to some extent; compared with embodiment 1, because content of epoxy resin in the adhesive is reduced in embodiment 22, the adhesion force of the nickel metal layer is reduced, thereby the mechanical property of the shielding structure is reduced to some extent; compared with embodiment 1, because content of a curing agent is reduced in embodiment 23, the adhesion force of the nickel metal layer is reduced, thereby the mechanical property of the shielding structure is reduced to some extent; compared with embodiment 1, because the accelerant is reduced in embodiment 24, the adhesion force of the nickel metal layer is reduced, thereby the mechanical property of the shielding structure is reduced to some extent; compared with embodiment 1, because a curing temperature of the adhesive is reduced in embodiment 25, the adhesion force of the nickel metal layer is reduced, thereby the mechanical property of the shielding structure is reduced to some extent; compared with embodiment 1, the curing time of the adhesive is prolonged in embodiment 26, however the performance of the obtained shielding structure is the same as that in the embodiments, and the performance is not reduced, this is because the curing time in the embodiment is smaller compared with aging deforming time, while the curing time of the adhesive reaches preset time, the curing can be completed, and bonding performance reaches maximum strength, the mechanical property can be reduced only if time of continuously curing exceeds the aging deforming time; compared with embodiment 1, because the pressure of pressing is smaller in embodiment 27, the adhesion force of the nickel metal layer is reduced, thereby the mechanical property of the shielding structure is reduced to some extent; compared with embodiment 1, because a thickness of a cupper net is thicker in embodiment 28, the shielding effectiveness of the shielding structure to some frequency bands of signals is increased, and the mechanical property of the shielding structure is reduced to some extent; and compared with embodiment 1, because the thickness of the permalloy layer is thicker in embodiment 29, the shielding effectiveness of the shielding structure to some frequency bands of the signals is increased, and the mechanical property of the shielding structure is reduced to some extent.

Increase of the thickness of the carbon fiber fabric is capable of improving overall strength of the shielding structure, and a result of a change is tensile strength; increase of the thickness of the nickel-plated carbon fiber film is capable of enabling the shielding effectiveness of the shielding structure to a signal of which frequency is greater than 14 kHz to be increased, but increase of the shielding effectiveness to a signal greater than 10 GHz is not apparent; increase of the thicknesses of the permalloy layer and the metal net is capable of enabling the shielding effectiveness to a signal of which a frequency band is below 14 kHz to be increased, but the increase of the shielding effectiveness to a high-frequency signal greater than 10 GHz is not apparent; increase of the number of the shielding components is capable of increasing the shielding effectiveness of the shielding structure to signals in all frequency bands, but the increase is not in equal proportion, and an increase effect of more than 6 shielding components is not apparent; a result generated by a change of a plating solution condition is to reduce quality of the nickel plated carbon fibers, thereby the shielding effectiveness is affected; and a change of components and conditions of the adhesive only affects the mechanical property.

It can be observed from the description that the embodiments of the present disclosure achieve the following technical effects:
1) In the nickel-plated carbon fiber film of the present disclosure, metal colloid particles are adhered to carbon fiber base fabric, the metal colloid particles have adhesion, so the nickel metal layer is adhered to the carbon fiber base fabric better, and electromagnetic shielding effectiveness of the nickel-plated carbon fiber film is further reinforced, so that the nickel-plated carbon fiber film not only has the better mechanical property and physical property, but also has the better electromagnetic shielding effectiveness.
2) Because the shielding structure of the present disclosure includes the nickel-plated carbon fiber film, the shielding structure has the better mechanical property, physical property and electromagnetic shielding effectiveness.
3) In the manufacturing method of the nickel-plated carbon fiber film of the present disclosure, firstly the metal colloid particles are arranged on the carbon fiber base fabric, the metal colloid particles has the adhesion, and the nickel metal layer is arranged on an exposed surface of the carbon fiber base fabric and a surface, away from the carbon fiber base fabric, of the metal colloid particles, the nickel metal layer is adhered to the carbon fiber base fabric better because of the adhesion of the metal colloid particles, the electromagnetic shielding effectiveness of the nickel-plated carbon fiber film is further reinforced, so that the nickel-plated carbon fiber film not only has the better mechanical property and physical property, but also has the better electromagnetic shielding effectiveness.
4) Because the preparation method of the shielding structure of the present disclosure includes the manufacturing method, efficiency of the preparation method is higher and the prepared shielding structure has the better mechanical property and physical property and electromagnetic shielding effectiveness.

The above are only the optimal embodiments of the present disclosure, and not intend to limit the present disclosure, various changes and variations can be made to the present disclosure by those skilled in the art. Within spirits and principles of the present disclosure, any made modifications, equivalent replacements, improvements and the like shall fall within a scope of protection of the present disclosure.

## Claims

1. A nickel-plated carbon fiber film, wherein the nickel-plated carbon fiber film (3) comprises:
at least one carbon fiber base fabric (31), wherein metal colloid particles (32) are adhered to a surface of the carbon fiber base fabric (31); and
at least one nickel metal layer (33), arranged on a naked surface of the carbon fiber base fabric (31) and a surface, away from the carbon fiber base fabric (31), of the metal colloid particles (32).

2. The nickel-plated carbon fiber film as claimed in claim 1, wherein the metal colloid particles (32) are Pb colloid particles or Ag colloid particles.

3. A shielding structure, comprising at least one shielding component, wherein the shielding component comprises the nickel-plated carbon fiber film (3) as claimed in claim 1 or 2.

4. The shielding structure as claimed in claim 3, wherein the shielding component further comprises:
at least one carbon fiber fabric (1), wherein the nickel-plated carbon fiber film (3) is arranged on a side surface of the carbon fiber fabric (1), and preferably a thickness of one or more the carbon fiber fabric (1) is between 0.13 and 1.0 mm.

5. The shielding structure as claimed in claim 4, wherein the shielding component further comprises:
at least one metal net (2), arranged between the nickel-plated carbon fiber film (3) and the carbon fiber fabric (1), preferably the metal net (2) is a copper net, and further preferably a thickness of the metal net (2) is between 0.005 and 0.015 mm.

6. The shielding structure as claimed in claim 5, wherein the shielding component further comprises:
at least one permalloy layer (4), arranged on a surface, away from the metal net (2), of the nickel-plated carbon fiber film (3), preferably a thickness of the permalloy layer (4) is between 0.05 and 0.20 mm, further preferably the shielding component comprises a plurality of stacked nickel-plated carbon fiber films (3), a total thickness of the plurality of nickel-plated carbon fiber films (3) is between 0.7 and 1.2 mm.

7. The shielding structure as claimed in claim 3, wherein the shielding structure comprises a plurality of the shielding components, each of the plurality of shielding components is stacked, the shielding structure further comprises:
at least one adhesive layer, arranged between any adjacent two of the shielding components and between any adjacent two of structure layers in each of the shielding components, preferably a raw material of the adhesive layer comprises 80-120 parts by weight of epoxy resin, 60-80 parts by weight of curing agent, and 0.5-2.5 parts by weight of accelerant, further preferably the curing agent is methyl tetrahydrophthalic anhydride, and the accelerant is boron trifluoride ethylamine.

8. A manufacturing method of a nickel-plated carbon fiber film, wherein the manufacturing method comprises:
step S1, providing at least one carbon fiber base fabric;
step S3,arranging metal colloid particles on the carbon fiber base fabric; and
step S4,arranging at least one nickel metal layer on a naked surface of the carbon fiber base fabric and a surface, away from the carbon fiber base fabric, of the metal colloid particles.

9. The manufacturing method as claimed in claim 8, wherein between the step S1 and the step S3, the manufacturing method further comprises:
step S2, treating surfaces of the carbon fiber base fabric, as to remove organic matters on the surface of the carbon fiber base fabric.

10. The manufacturing method as claimed in claim 9, wherein the step S2 comprises the following steps:
soaking the carbon fiber base fabric with acetone;
soaking the carbon fiber base fabric soaked with the acetone with mixed solution of a hydrofluoric acid and a strong acid; and
washing the soaked carbon fiber base fabric with water.

11. The manufacturing method as claimed in claim 10, wherein the strong acid is a sulfuric acid, a hydrochloric acid or a nitric acid, preferably a molar ratio of the hydrofluoric acid and the strong acid is between 1:3 and 1:1, further preferably a volume concentration of the mixed solution is between 5% and 15%, and more preferably in the step S2, a time of soaking the carbon fiber base fabric with the mixed solution is between 5min and 30 min.

12. The manufacturing method as claimed in claim 8, wherein the step S3 comprises:
step S31, soaking the carbon fiber base fabric with a dilute acid solution of a reducing metal salt; and
step S32, activating the carbon fiber base fabric treated in the step S31 with a dilute acid solution of an oxidizing metal salt, as to generate the metal colloid particles, preferably the oxidizing metal salt is PdCl₂ or AgNO₃, and further preferably the reducing metal salt is SnCl₂.

13. The manufacturing method as claimed in claim 12, wherein the dilute acid solution of the reducing metal salt is a first hydrochloric acid solution, and in the first hydrochloric acid solution, a mass concentration of the SnCl₂ is between 4% and 8%, preferably a soaking temperature of the step S31 is between 25 ºC and 40 ºC, and a soaking time is between 20 min and 50 min.

14. The manufacturing method as claimed in claim 12, wherein the oxidizing metal salt is PdCl₂, the dilute acid solution of the oxidizing metal salt in the step S32 is a second hydrochloric acid solution, and in the second hydrochloric acid solution, a mass concentration of the PdCl₂ is between 0.02% and 0.04%, preferably a temperature of the dilute acid solution of the PdCl₂ is between 25ºC and 40ºC, and a time of the activating is between 10 min and 50 min.

15. The manufacturing method as claimed in claim 12, wherein
after soaking the carbon fiber base fabric with the dilute acid solution of SnCl₂, the step S31 further comprises:
washing the carbon fiber base fabric with water,
wherein the oxidizing metal salt is PdCl₂, after activating the carbon fiber base fabric with the dilute acid solution of PdCl₂, the step S32 further comprises:
washing the carbon fiber base fabric with water.

16. The manufacturing method as claimed in claim 8, wherein the step S4 comprises:
adopting a plating solution, and arranging the nickel metal layer with an electroless nickel plating,
preferably the plating solution comprises 40-60 parts by weight of nickel salt, 40-60 parts by weight of reducing agent, 80-120 parts by weight of complexing agent, 40-60 parts by weight of buffering agent and 0.15-0.25 parts by weight of surfactant, further preferably a pH value of the plating solution is 10-11.

17. The manufacturing method as claimed in claim 16, wherein the nickel salt comprises nickel sulfate, the reducing agent comprises sodium hypophosphite, the complexing agent comprises sodium citrate, the buffering agent comprises ammonium chloride, and the surfactant comprises sodium dodecyl benzene sulfonate, preferably a temperature of the plating solution is between 40 ºC and 60ºC, further preferably an implementation time of the electroless nickel plating is between 20 and 50 min.

18. A preparation method of a shielding structure, the preparation method comprises a manufacturing process of at least one shielding component, wherein the manufacturing process comprises the manufacturing method of the nickel-plated carbon fiber film as claimed in any one of claims 8 to 17.

19. The preparation method as claimed in claim 18, wherein the manufacturing process further comprises:
providing a carbon fiber fabric; and
arranging at least one metal net and the nickel-plated carbon fiber film on the carbon fiber fabric sequentially,
preferably the manufacturing process further comprises:
arranging at least one permalloy layer on a surface, away from the metal net, of the nickel-plated carbon fiber film, as to form a pre-shielding component.

20. The preparation method as claimed in claim 19, wherein the preparation method further comprises:
hot pressing on the pre-shielding component or hot pressing on a plurality of stacked pre-shielding components, as to form the shielding structure.

21. The preparation method as claimed in claim 20, wherein a process of the hot pressing comprises:
arranging an adhesive between the adjacent structure layers to be hot pressed, as to form a pre-hot press structure;
pressing the pre-hot press structure; and
curing the adhesive in the pre-hot press structure after pressing,
preferably the adhesive comprises 80-120 parts by weight of epoxy resin, 60-80 parts by weight of curing agent, and 0.5-2.5 parts by weight of accelerant, preferably the curing agent is methyl tetrahydrophthalic anhydride, the accelerant is boron trifluoride ethylamine,
further preferably a pressure of the pressing is between 0.4 MPa and 0.8 MPa, and
more preferably the curing is heat curing, and a temperature of the heat curing is between 120ºC and 150ºC, and a time of the heat curing is between 1 h and 3 h.
